# EUROPEAN PATENT APPLICATION

(11) **EP 2 202 812 A1**
(43) Date of publication of application: **30.06.2010**
(21) Application number: 08835113.5
(22) Date of filing: 30.09.2008
(51) Int. Cl.: H01L 35/30, H01L 35/14, H02N 11/00

(54) **THERMOELECTRIC GENERATING DEVICE**

(30) Priority: 02.10.2007 JP 2007259054
(71) Applicant: Kabushiki Kaisha Toshiba, Minato-ku Tokyo 105-8001 (JP)
(72) Inventor: INATOMI, Takanari, Tokyo 105-8001 (JP); NAKAMURA, Hiroshi, Tokyo 105-8001 (JP); KONDO, Naruhito, Tokyo 105-8001 (JP); TSUNEOKA, Osamu, Tokyo 105-8001 (JP)
(74) Representative: Kramer - Barske - Schmidtchen
(86) International application number: PCT/JP2008/067731
(87) International publication number: WO 2009/044728

(57) **Abstract**

A thermoelectric generator includes: a high temperature member which conducts thermal energy of a high temperature medium; a low temperature member which is provided on a side opposing to the high temperature medium of the high temperature member and is provided with a low temperature medium passage therein; a thermoelectric module which is sandwiched between the high temperature member and the low temperature member and carries out a thermoelectric conversion element converting a thermal energy to an electrical energy using a temperature difference between the high temperature medium and the low temperature medium supplied to the low temperature medium passage, and at least one tie rod fastening between the low temperature member and the high temperature member.

## Description

### Technical Field

The present invention relates to a thermoelectric generator which uses a thermoelectric module to convert thermal energy to electrical energy using a temperature difference, and more particularly, to a thermoelectric generator capable of efficiently generating electricity by a wide use of high-temperature fluids or other various kinds of heat sources emitting radiant heat.

### Background Technology

In recent years, with advancement of industry and science and technology, an amount of energy consumed by humans has been increased unprecedentedly at an accelerated speed. As a result, an inconvenient matter of global warming due to greenhouse gases such as CO₂ is emerging.

In light of the above fact, in order to suppress the generation of greenhouse gases as much as possible, there is currently expected the commercialization of a power generator which recovers high-temperature thermal energy discarded unused from not only various industries such as gas incinerators and thermal power plants but also internal combustion engines of automobiles and the like as electrical energy as much as possible.

As a power generator recovering thermal energy as electrical energy, there has been well known a power generation technique using thermoelectric elements. The thermoelectric element uses the Seebeck effect where a temperature difference is given between both ends of a metal or a semiconductor to thereby produce a potential difference between a high temperature portion and a low temperature portion. The thermoelectric element has such characteristics as that the larger the temperature difference is the larger the power generation. In general, thermoelectric elements have frequently been used as a thermoelectric module incorporating a plurality of thermoelectric elements.

As a thermoelectric generator using such a thermoelectric module, there have been conventionally proposed various kinds of configurations thereof for the purpose of transferring the exhaust gas thermal energy of an internal combustion engine to the electrical energy, where a thermoelectric module is held in a pressed state by being tightened with bands or the like, a high temperature member and a low temperature member are made in contact with a high temperature surface and a low temperature surface of the thermoelectric module respectively, and according to this configuration, the thermal energy is converted to the electrical energy (for example, see Patent Document 1: Japanese Patent Application Laid-Open Publication No. 2005-223131 and Patent Document 2: Japanese Patent Application Laid-Open Publication No. 2004-208476).
Most of the conventionally proposed thermoelectric generators including the aforementioned thermoelectric generator relate to the configuration where a high temperature fluid as a heat source is made to flow through a heat transfer tube provided in the center portion of the generator. In addition, a plurality of thermoelectric modules is fixed to the surface of the heat transfer tube in a pressed state by being collectively tightened by bands or the like from the surroundings thereof. Consequently, an uneven surface pressure occurs on the contact surface among the high temperature heat source, the thermoelectric module, and the low temperature member depending on the position of providing the thermoelectric modules and the degree of tightening the bands, which frequently affects the performance of the generator. Moreover, there is no configuration where the thermoelectric module is directly connected to the low temperature member with a member extending from the high temperature heat source.

For this reason, the generator can be installed only to the heat source having a shape of a heat transfer tube, and thus, there is a limit to the application of the generator to many heat sources of high temperature fluids or heat sources emitting radiant heat being used in various industrial facilities.

### Disclosure of the Invention

In view of the above circumstances, the present invention has been made, and an object of the present invention is to provide a thermoelectric generator capable of providing an efficient conversion from thermal energy to electrical energy by being provided directly to or slightly spaced from an existing high temperature heat source in various kinds of industrial facilities, having a compact and high performance power generation function, and being excellent in structural health and operability such as mounting and maintenance.

In order to achieve the above object, the present invention provides a thermoelectric generator comprising: a high temperature member which conducts thermal energy of a high temperature medium; a low temperature member which is provided on a side opposing to the high temperature medium of the high temperature member and is provided with a low temperature medium passage thereinside; a thermoelectric module which is sandwiched between the high temperature member and the low temperature member and carries out a thermoelectric conversion element converting thermal energy to electrical energy using a temperature difference between the high temperature medium and the low temperature medium supplied to the low temperature medium passage; and at least one tie rod fastening between the low temperature member and the high temperature member.

Further, in the present invention mentioned above, the high temperature member may have two surfaces in parallel to each other, the thermoelectric module and the low temperature member are provided on each of the parallel surfaces of the high temperature member, and the low temperature members are fastened together by the tie rod.

In addition, it may be desirable that the present invention should be configured such that the high temperature member has two parallel surfaces and a through-hole connecting the two parallel surfaces, the thermoelectric module and the low temperature member are provided on each of the parallel surfaces of the high temperature member, and the low temperature members are fastened together by the tie rod.

Furthermore, the present invention may be configured so that the low temperature member, the thermoelectric module, and the tie rod are combined into one unit, and a plurality of the units are arranged on the high temperature member.

Still furthermore, it may be desired that, as a member for fastening the low temperature member and the high temperature member with the tie rod, a plurality of spring members whose contact portion forms a line contact are provided.

Still furthermore, the present invention may be configured so that the low temperature member includes a base material and a passage material forming a passage, and a rigidity of the passage material is equal to or greater than a rigidity of the base material.

In addition, the base material may be formed with an element selected from aluminum, copper, iron, molybdenum, titanium, nickel, tin, zirconium, zinc, and magnesium, or a compound or an alloy containing any one of the above elements as its main component.

In addition, the thermoelectric conversion element may be a direct thermoelectric conversion semiconductor formed with at least three or more elements selected from rare earth element, uranium, thorium, plutonium, cobalt, nickel, iron, rhodium, ruthenium, palladium, platinum, antimony, titanium, zirconium, hafnium, tin, silicon, manganese, zinc, boron, carbon, nitrogen, oxygen, gallium, germanium, indium, vanadium, niobium, barium, magnesium, chromium, tantalum, molybdenum, and aluminum.

Furthermore, in the present invention, the direct thermoelectric conversion semiconductor may have a crystal structure of any one of a skutterudite structure, a filled skutterudite structure, a Heusler structure, a half-Heusler structure, and a clathrate structure.

In addition, in the present invention mentioned above, the crystal structure of the direct thermoelectric conversion semiconductor may be at least one or a compound or a mixture or a solid solution of a layered complex oxide of cobalt and a substance selected from copper oxide, carbon, boron, sodium, and calcium; aluminum nitride; uranium nitride; silicon nitride; molybdenum disulfide; a thermoelectric conversion material containing cobalt antimonide compound having a skutterudite crystal structure as the main phase; a thermoelectric conversion material containing clathrate compound as the main phase; and a thermoelectric conversion material containing half-Heusler compound as the main phase.

According to the present invention of the characters mentioned above, there is provided a thermoelectric generator capable of providing an efficient conversion from the thermal energy to the electrical energy with a compact structure at high performance power generation function, and being excellent in structural health and operability such as mounting and maintenance.

### Brief Description of the Drawings

[Fig. 1] is a sectional view illustrating a thermoelectric generator according to a first embodiment of the present invention (sectional view along line I-I in Fig. 2).
[Fig. 2] is a perspective view illustrating a unit of the thermoelectric generator according to the first embodiment of the present invention.
[Fig. 3] is a perspective view illustrating a low temperature member of the thermoelectric generator according to the first embodiment of the present invention.
[Fig. 4] is a sectional view illustrating a passage configuration of a thermoelectric module of the thermoelectric generator according to the first embodiment of the present invention (sectional view along line IV-IV in Fig. 1).
[Fig. 5] is an entire structural view illustrating the thermoelectric generator according to the first embodiment of the present invention.
[Fig. 6] is a sectional view illustrating a thermoelectric generator according to a second embodiment of the present invention.
[Fig. 7] is a sectional view illustrating a thermoelectric generator according to a third embodiment of the present invention.
[Fig. 8] is a perspective view illustrating a unit of a thermoelectric generator according to a fourth embodiment of the present invention.
[Fig. 9] is a sectional view along line IX-IX in Fig. 8.
[Fig. 10] is a perspective view illustrating a low temperature member of the thermoelectric generator according to the fourth embodiment of the present invention.
[Fig. 11] is a sectional view illustrating a passage configuration of a thermoelectric module of the thermoelectric generator according to the fourth embodiment of the present invention (sectional view along line XI-XI in Fig. 9).
[Fig. 12] is an entire structural view illustrating the thermoelectric generator according to the fourth embodiment of the present invention.
[Fig. 13] is a sectional view illustrating a thermoelectric generator according to a fifth embodiment of the present invention.

### Best Mode for Carrying Out the Invention

Hereinafter, embodiments of the thermoelectric generator according to the present invention will be described with reference to the accompanying drawings.

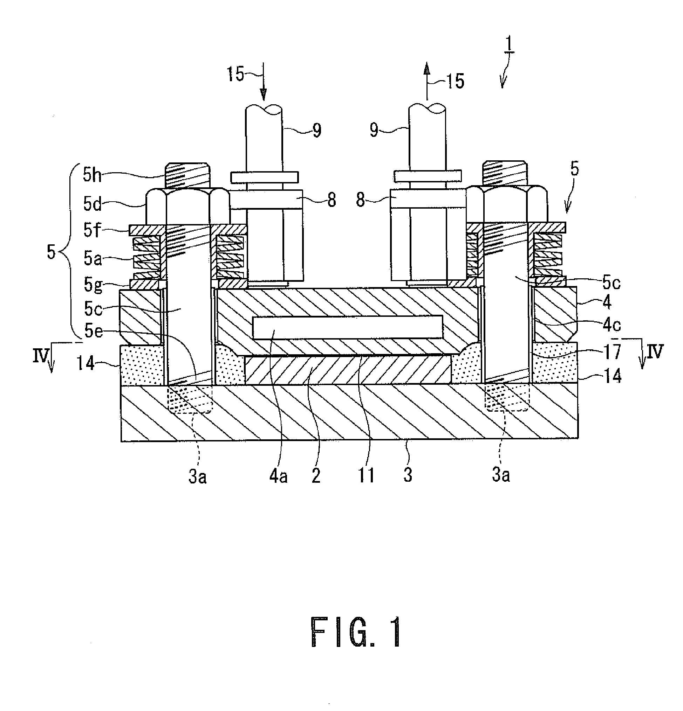

### [First Embodiment (Figs. 1 to 5)]

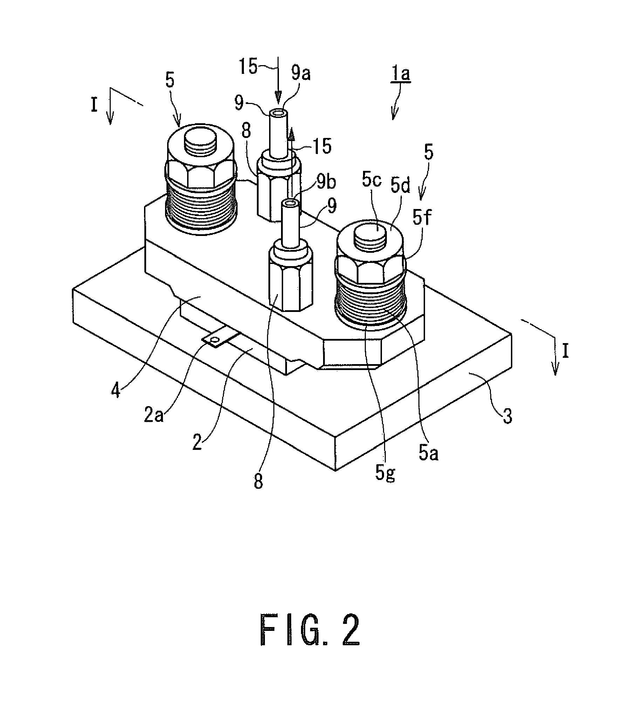

As illustrated in Figs. 1 and 2, a thermoelectric generator 1 of the present embodiment includes a high temperature member 3 which receives heat by conduction of thermal energy supplied from a heat source (not illustrated), a thermoelectric module 2 which receives heat with one surface (bottom surface) thereof being in contact with the high temperature member 3, and a low temperature member 4 which cools the other surface of the thermoelectric module 2 by flowing a low temperature medium 15 supplied from a cooling facility (not illustrated) thereinside.

The high temperature member 3 is, for example, of a flat plate shape, a plurality of (two in the figure) screw holes 3a are formed on one side surface thereof, and a tie rod 5c is inserted into each screw hole 3a by screwing the tie rod. Further, the tie rod 5c may be mounted on the high temperature member 3 by bolt fastening or welding. Moreover, a high temperature wall, not illustrated, incorporating a heat source may be directly used as the high temperature member 3, and the tie rod may be directly connected to the high temperature member 3.

The thermoelectric module 2 is of a rectangular plate shape having a predetermined thickness and is disposed in contact with one side surface (upper surface in Fig. 1) of the high temperature member 3 to be heated in contact with the high temperature member 3. In addition, a low temperature member 4 is, for example, configured in such a manner that a plurality of plates having grooves formed by mechanical processing is laminated and each plate is joined by brazing to form a rectangular shape. The low temperature member 4 is disposed in contact with the outer surface (upper surface in Fig. 1) of the thermoelectric module 2.

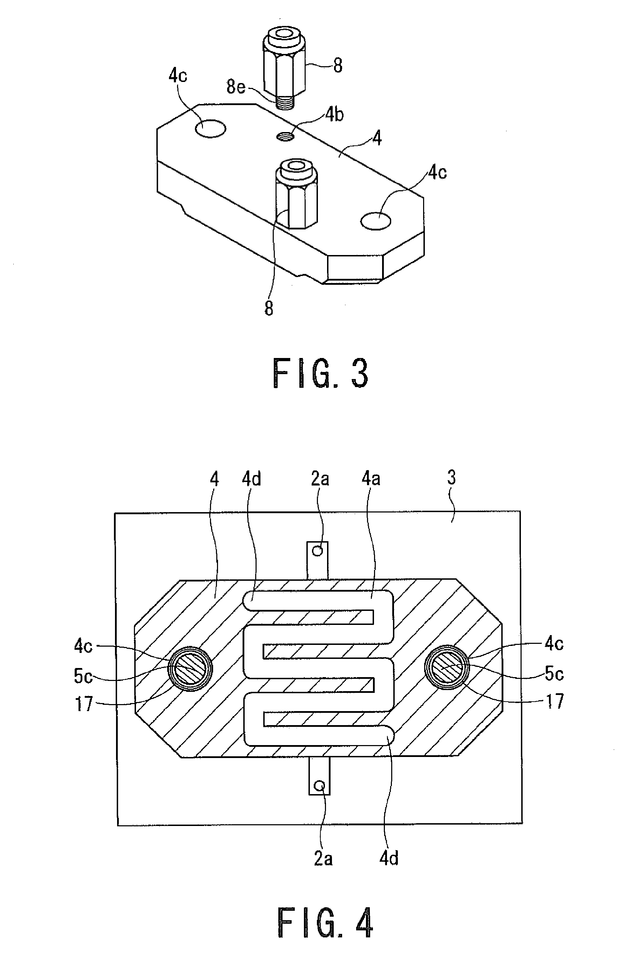

Fig. 3 illustrates a mounting structure in which a joint 8 is mounted on the low temperature member 4. As illustrated in Fig. 3, a cooling medium entrance/exit portion 4b of the low temperature medium passage 4a is formed in an outer surface of the low temperature member 4, for example, as a screw hole, and is mounted in such a manner that the joint 8 for piping connection is inserted by screwing the joint 8.

Fig. 4 is a sectional view along line IV-IV in Fig. 1, and illustrates a configuration of the low temperature medium passage 4a of the low temperature member 4 and the like. As illustrated in Fig. 4, the low temperature member 4 includes the low temperature medium passage 4a which is formed, for example, as a serpentine passage, to supply a low temperature medium from a cooling facility (not illustrated). Both ends of the low temperature medium passage 4a form joint mounting positions 4d and 4d of the joints 8 and 8, respectively. The outer surface of the thermoelectric module 2 illustrated in Figs. 1 and 2 is in contact with the low temperature member 4 and the thermoelectric module 2 is cooled from the outer surface side of the thermoelectric generator.

As illustrated in Fig. 1, the thermoelectric generator 1 includes a pressing member 5. The pressing member 5 has a thermal expansion absorption function to press the low temperature member 4 against the high temperature member side. More specifically, the pressing member 5 has a tie rod 5c to which screw portions 5e and 5h are formed on both ends thereof. The screw portion 5e on one end side of the tie rod 5c is screwed into a screw hole 3a formed in a surface of the high temperature member 3. Moreover, around the tie rod 5c, there are provided a washer 5g, a spring member 5a such as a disc spring, which is an elastic member formed by laminating a plurality of spring plates so as to press the low temperature member 4, and a flanged sleeve 5f serving as a guide of the spring member 5a. These components are fastened by a nut 5d screwed into a screw portion 5h provided on the other end side of the tie rod 5c.

As described above, the present embodiment includes a plurality of (two) tie rods 5c fastening the low temperature member 4 and the high temperature member 3. The present embodiment is configured such that the sleeve 5f serving as a guide of the spring member 5a and the washer 5g are provided on both end portions of the spring member 5a so as to elastically press the thermoelectric module 2, the heat insulating material 14, and the low temperature member 4.

In this configuration, during operation, a difference between a thermal expansion coefficient and a difference in temperature distribution causes a thermal expansion difference to occur between the tie rod 5c and a thermal exchange unit composed of the high temperature member 3, the thermoelectric module 2, and the low temperature member 4. According to an increase in temperature, although the fastening force between the tie rods 5c and the thermal exchange unit is lost due to the thermal expansion difference, the spring member 5a is pressed in advance and thus can prevent the loss of the fastening force therebetween.

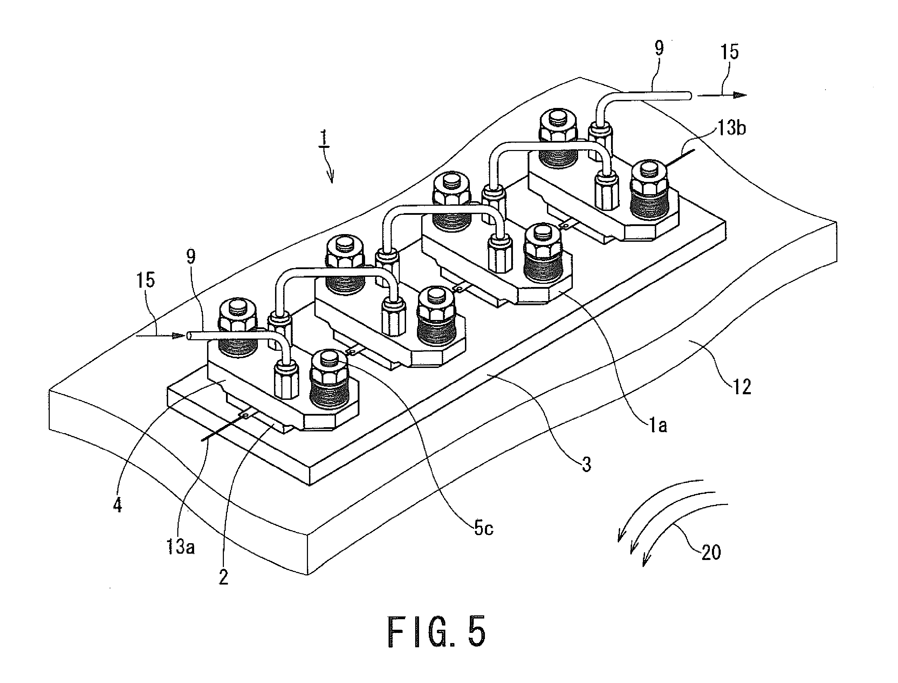

Fig. 5 illustrates a configuration of a thermoelectric generator 1, where the configuration of Fig. 1 including the low temperature member 4, the thermoelectric module 2, the tie rod 5c, and the like is treated as one unit of thermoelectric generator unit 1a, and a plurality of units 1a is mounted on the high temperature member 3 as the plurality of units. The thermoelectric generator 1 is configured by evenly mounting four thermoelectric generator units 1a on the high temperature member 3, and, for example, is mounted on an existing high temperature wall 12. The thermoelectric generator 1 generates power by receiving a high temperature convection 20 and supplies the generated power to an outside portion through a common electrical wiring 13 (plus (+) electrode side 13a and minus (-) electrode side 13b). Further, it is to be noted that the number of units may be adjusted depending on the size of the high temperature wall 12 and the amount of power generation. It is also noted that thermoelectric generator 1 may be mounted on the high temperature wall 12 by welding or by hastening, or if possible, the tie rod 5c thereof may be directly joined to the high temperature wall 12.

Herein, with reference to Figs. 1 to 5, the configuration of the present embodiment will be further described in detail.
As illustrated in these figures, the thermoelectric generator 1 of the present embodiment is configured such that the high temperature member 3 and the low temperature member 4 are pressed by the spring member 5a such as a disc spring for absorbing the thermal expansion. According to this configuration, the amount of screwing the nut 5d can be adjusted so as to adjust the force of pressing the thermoelectric module 2 sandwiched between the high temperature member 3 and the low temperature member 4 through the pressing member 5 including the spring member 5a and the like. A reaction force from the spring member 5a is received by the tie rod 5c.

In this manner, the pressing member 5 having a function to generate the pressure load and absorb the thermal expansion presses the thermoelectric module 2 in contact with the high temperature member 3 against the low temperature member 4 by a predetermined force. This pressure force increases the adhesion between the high temperature member 3 and the thermoelectric module 2, and thus, reduces the contact thermal resistance between the high temperature member 3 and the thermoelectric module 2. The nut 5d is screwed into the screw portion 5h formed on the upper end of the tie rod 5c. Accordingly, a rotation of the nut 5d can be converted into a movement in a perpendicular direction with respect to the spring member 5a. Therefore, the bending amount or pressing force of the spring member 5a can be adjusted with a high precision.

During high temperature operation, the spring member 5a receives heat from the high temperature member 3 through the tie rod 5c. The disc spring of the spring member 5a is in line contact with the washer 5f, thus suppressing an increase in temperature thereof. Further, the disc spring of the spring member 5a is in line contact with the washer 5g in contact with the low temperature member 4, and thus, only a small amount of heat is transferred to the low temperature member 4.

Moreover, by maintaining the temperature of the spring member 5a to be low, the spring constant can be prevented from lowering. Further, the amount of heat escaping to the spring member 5a and the low temperature member 4 can be reduced, thus effectively reducing the thermal energy loss. Further, the temperature of the tie rod 5c is assumed to be a high temperature of 400°C or higher depending on the facility used as the heat source, and thus, it is required for the tie rod 5c to be made of a material having creep strength.

In this viewpoint, it is desirable that the material of the tie rod 5c should be, for example, an austenitic stainless steel such as SUS 316 and SUS 304; a chromium molybdenum steel such as 21/4Cr-1Mo, 9Cr-1Mo, and improved 9Cr-1Mo; a high nickel alloy such as NCF 600; or an oxide dispersion strengthened steel. Further, if a material having a low thermal expansion coefficient is used for the tie rod 5c, the amount of spring member 5a may be reduced.

Since the tie rod 5c passes through a tie rod through-hole 4c formed in the low temperature member 4, the mutual distance becomes relatively small. In order to reduce the thermal energy loss, an anti-radiation plate 17 is inserted between the tie rod 5c and the low temperature member 4. It is desirable that the anti-radiation plate 17 should be made of a material having low radiation, and thus a thin metal plate such as stainless steel, carbon steel, or aluminum alloy should be used. As the shape of the anti-radiation plate 17, a tube-shaped thin plate is easy to be assembled, and a plurality of layered tube-shaped thin plates has an insulation superior to a single layer of a tube-shaped thin plate.

In order to suppress the thermal energy loss, a heat insulating material 14 is provided on a portion of the high temperature member 3 which is not in contact with the thermoelectric module 2. The material of the low temperature member 4 is required to have strength against a temperature of about 150°C, low gravity to be light weight, corrosion resistance to the low temperature medium 15, and high thermal conductivity. Consequently, it is desirable to apply aluminum alloy such as A6061, for example, on which anodizing (alumite treatment) is performed. If further light weight, strength, and corrosion resistance are strongly required, titanium alloy may be effective. On the contrary, if light weight is not required, austenitic stainless steel such as SUS 304 may be used. Moreover, it is effective that the base material is formed of aluminum alloy and an annealed stainless steel pipe is buried into the passage by HIP processing so as to improve corrosion resistance and reduce weight. Furthermore, it is to be noted that the low temperature member includes the base material and a passage material forming the passage, and the rigidity of the passage material is equal to or greater than the rigidity of the base material.

In addition, the base material may be formed of an element selected from aluminum, copper, iron, molybdenum, titanium, nickel, tin, zirconium, zinc, magnesium, or a compound or an alloy containing any one of the above elements as its main component.

The low temperature medium passage 4a is formed inside the low temperature member 4. A joint 8 is mounted on the entrance/exit 4b of the low temperature medium 15 provided on the upper surface of the low temperature member 4. Although Fig. 3 illustrates a configuration in which the joint 8 of the low temperature medium 15 is mounted on the upper surface of the low temperature member 4, the joint 8 may be mounted on a side surface of the low temperature member 4. A pipe 9 such as a steel pipe, a copper tube, or a fluororesin tube is connected to the joint 8 so as to flow the low temperature medium 15 across a plurality of low temperature members 4. Here, if the low temperature member 4 is made by HIP processing by applying aluminum alloy and stainless steel pipe, the stainless steel pipe may be made to extend from the low temperature member 4. Therefore, since it is not required for the low temperature member 4 to be provided with the cooling medium entrance/exit portion 4b, the connection of the pipe 9 can be easily done.

According to the thermoelectric generator 1 of the present embodiment, as described above, the configuration of Fig. 2 is treated as one unit, and on the other hand, as illustrated in Fig. 5, a plurality of units (e.g., four units) are consecutively mounted on the surface of the high temperature member 3. It should be noted that the number of units is not limited to these structures, and a further number of units may be mounted as needed so as to increase the amount of power generation.

The low temperature medium 15 is supplied to the low temperature member 4 of each unit through the pipe 9 via an entrance header (not illustrated). The low temperature medium 15 flows through across a plurality of low temperature member 4 of each unit. The low temperature medium 15 heated during the power generation is returned to an exit header (not illustrated) through the pipe 9.

According to the structure mentioned above, the pressing member 5 can adjust the bending amount of the spring member 5a so as to press each thermoelectric module 2 sandwiched between the high temperature member 3 and the low temperature member 4 by a predetermined force, and to hence effectively cause a temperature difference to occur on the upper and lower surfaces of the thermoelectric module 2.

Further, although the temperature difference causes a thermal expansion difference to occur between the pressing member 5 and the high temperature member 3, the thermoelectric module 2 and the low temperature member 4, the pressing member 5 is provided with the spring member 5a, and the initial amount of fastening by the spring member 5a can be set at assembly so as to generate an appropriate pressing force to the thermoelectric module 2 during normal operation and so as not to generate an excessively small pressing force enough to undermine the performance of the thermoelectric module 2 even under a maximum temperature condition. Therefore, the soundness of the thermoelectric module 2 can be maintained at the assembling time.

In a case of mounting the thermoelectric generator 1 of the present embodiment on an existing high temperature wall 12 in various industrial plants and the like, a jig having a good adhesive performance to the surface condition of the high temperature wall 12 and the thermoelectric module 2, a high thermal conductivity may be provided between the high temperature member 3, and in addition, the thermoelectric module 2 and may be fixed by volt fastening or welding.

Moreover, if possible, the thermoelectric generator 1 may be directly mounted on the high temperature wall 12 instead of the high temperature member 3. Further, if the high temperature wall 12 has a bad surface state such as a rough surface, the high temperature wall 12 and the high temperature member 3 may be spaced apart by a predetermined distance, and the radiant heat may be used as the heat source.

Further, the high temperature member 3 is frequently exposed to corrosive fluids, and as described above, the temperature is assumed to be a high temperature of 400°C or higher. Therefore, it is required for the materials to have corrosion resistance and high temperature strength. In addition, welding and machining are required, and it is hence desirable that the material of the high temperature member 3 is chromium molybdenum steel, ferritic stainless steel, or austenitic stainless steel.

In order to reduce the contact thermal resistance between the high temperature member 3 and the thermoelectric module 2 or to equalize the temperature distribution, a heat transfer sheet may be provided therebetween. Here, it is desirable for the material of the heat transfer sheet to be a material having heat resistance and a large thermal conductivity such as graphite (black lead), copper, precious metal such as copper alloy and silver, and paint such as ceramic-based adhesive and putty. Furthermore, in order to reduce the contact thermal resistance between the thermoelectric module 2 and the low temperature member 4 or to equalize the temperature distribution, silicon grease 11 and the heat transfer sheet may be provided therebetween.

Further, a thermoelectric conversion element, not illustrated, incorporated in the thermoelectric module may be a direct thermoelectric conversion semiconductor formed of at least three or more elements selected from rare earth element, uranium, thorium, plutonium, cobalt, iron, rhodium, ruthenium, palladium, platinum, nickel, antimony, titanium, zirconium, hafnium, nickel, tin, silicon, manganese, zinc, boron, carbon, nitrogen, oxygen, gallium, germanium, indium, vanadium, niobium, barium, magnesium, chromium, tantalum, molybdenum, aluminum.

In addition, the crystal structure of the direct thermoelectric conversion semiconductor may contain any one or a compound or a mixture or a solid solution of a skutterudite structure, filled skutterudite structure, Heusler structure, half-Heusler structure, clathrate structure as its main component.

In addition, direct thermoelectric conversion semiconductor may be at least one or a compound or a mixture or a solid solution of a layered complex oxide of cobalt and a substance selected from copper oxide, carbon, boron, sodium, and calcium; aluminum nitride; uranium nitride; silicon nitride; molybdenum disulfide; a thermoelectric conversion material containing cobalt antimonide compound having a skutterudite crystal structure as the main phase; a thermoelectric conversion material containing clathrate compound as the main phase; and a thermoelectric conversion material containing half-Heusler compound as the main phase.

As described above, according to the present embodiment, the low temperature member 4, which is load-transferred by the pressing member 5 having a function to generate pressure load and absorb thermal expansion, is pressed to the thermoelectric module 2 being in contact with the high temperature member 3 by a predetermined force. This pressure force increases the adhesion between the high temperature member 3 and the thermoelectric module 2, thus reducing the contact thermal resistance between the high temperature member 3 and the thermoelectric module 2. Furthermore, since the nut 5d is screwed into the screw portion 5h formed on the upper end of the tie rod 5c, the rotation of the nut 5d can be converted to a movement in a perpendicular direction with respect to the spring member 5a. Therefore, the bending amount or pressing force of the spring member 5a can be adjusted with a good precision. Further, during operation, a difference between a thermal expansion coefficient and a difference in temperature distribution causes a thermal expansion difference to occur between the tie rod 5c and the thermal exchange unit consisting of the high temperature member 3, the thermoelectric module 2, and the low temperature member 4. However, the spring member 5a is pressed in advance by an amount more than thermal expansion, and hence, thus the loss of the fastening force can be prevented by the thermal expansion difference. Still furthermore, since the material of the low temperature member 4 has low gravity, corrosion resistance, and high thermal conductivity, the present embodiment can provide a thermoelectric generator capable of providing an efficient conversion from thermal energy to electrical energy, having a compact and high performance, and being excellent in structural soundness.

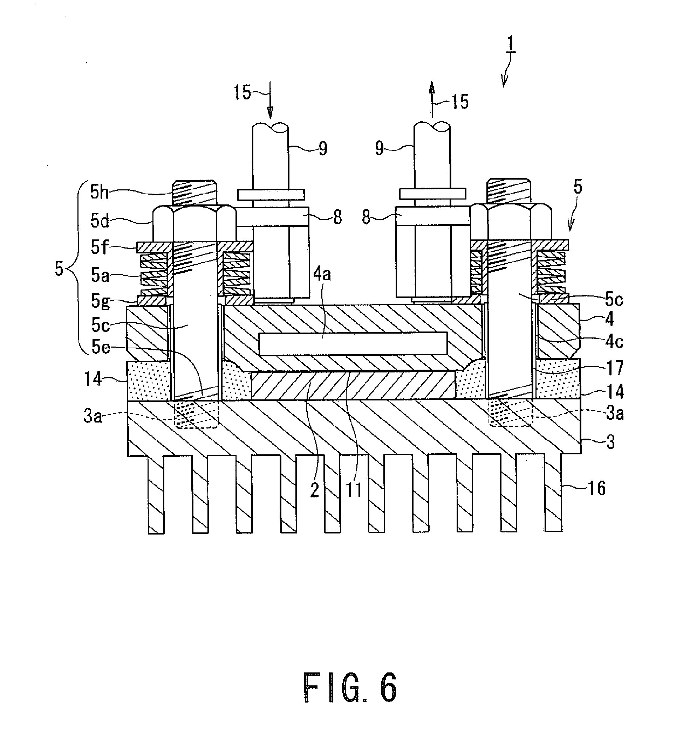

### [Second Embodiment (Fig. 6)]

The second embodiment of the present invention will be described with reference to Fig. 6. Fig. 6 is a sectional view illustrating a thermoelectric generator according to the present second embodiment. It is to be noted that the basic structure of this second embodiment is the same as that of the first embodiment, and thus, the same reference numerals or characters are assigned to components or like corresponding to those of the first embodiment, and the duplicate description is omitted herein.
The present embodiment focuses on a configuration in which a heat exchange fin 16 is formed on a high temperature medium side of the high temperature member 3.

More specifically, as shown in Fig. 6, a thermoelectric generator 1 of the present embodiment has the same structure or configuration as that of the first embodiment except that a plurality of fins 16 are formed on the bottom surface side of the high temperature member 3 in the drawing. The fins 16 are mounted on a pipe and a ractor wall through which a high temperature fluid flows so as to perform heat exchange. Thus, a high performance power generation can be provided.

Further, although the high temperature member 3 is, for example, of a flat plate shape, as illustrated in Fig. 6, the shape thereof is not limited thereto, and for example, the high temperature member 3 may form to provide a circular shape having curvature so as to be applicable to a circular pipe. In addition, a plurality of generators of the present embodiment may be connected in a circular tube shaped or rectangular tube shaped array to form a pipe arrangement which is connected to a pipe arrangement through which the high temperature fluid flows.

According to the above second embodiment, a thermoelectric generator cam provide an efficient conversion from thermal energy to electrical energy with a compact and simple structure at high performance, and being excellent in structural reliability and versatility.

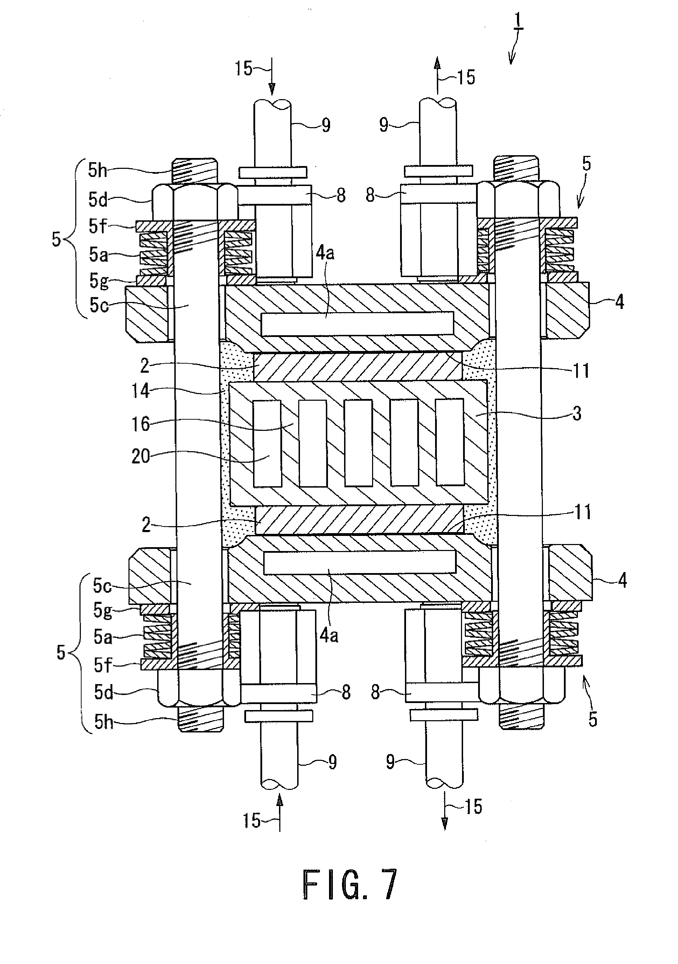

### [Third Embodiment (Fig. 7)]

The third embodiment of the present invention will be described hereunder with reference to Fig. 7. Fig. 7 is a sectional view illustrating a thermoelectric generator according to the third embodiment. It is to be noted that the basic configuration of the third embodiment is the same as those of the first and second embodiments, and hence, the same reference numerals or characters are assigned to components or like corresponding to those of the first and second embodiments, and the duplicate description is omitted herein.

The present embodiment shows a structure or configuration in which two units of the thermoelectric generator are disposed facing each other on a parallel surface of a rectangular passage 20 where the heat exchange fin 16 is formed on a high temperature medium side of the high temperature member 3.

As illustrated in Fig. 7, the thermoelectric generator 1 of the present embodiment has approximately the same configuration as that of the second embodiment except the fastening structure of the tie rod 5c. In the illustrated structure, the fin 16 is formed on the high temperature medium side of the high temperature member 3 so as to perform high performance heat exchange. Further, although the high temperature member 3 is of a rectangular shape as illustrated in Fig. 7, this shape is not limited thereto. In addition, although the thermoelectric generator unit is mounted on a flat surface, the high temperature medium passage may be of a circular shape. In this case, the pipe for introducing the high temperature medium should be formed to have a circular shape for easy connection.

According to the present embodiment, since the tie rod 5c is not directly fastened to the high temperature member 3, the temperature of the tie rod 5c is hard to increase. Consequently, during the operation, the amount of thermal expansion of the high temperature member 3 is larger than that of the tie rod 5c, and contrary to the second embodiment, the fastening force by the pressing member 5 is applied in a direction of increasing the fastening force. The fastening force increases the adhesion between the high temperature member 3 and the thermoelectric module 2, and reduces the contact thermal resistance between the high temperature member 3 and the thermoelectric module 2. Further, in the structure of Fig. 7, although the spring member 5a is mounted on both ends of the tie rod 5c, it may be mounted on one end side thereof.

The thermoelectric module 2 and the low temperature member 4 are disposed opposing and in parallel to a surface of the high temperature member 3, and are fastened by the tie rod 5c via the pressing member 5. Thus, a uniform contact surface pressure can be provided between the high temperature member 3 and the thermoelectric module 2, and between the thermoelectric module 2 and the low temperature member 4.

As described above, according to the present third embodiment, the thermoelectric generator can provide an efficient conversion from thermal energy to electrical energy with a compact structure at high performance, and being excellent in structural reliability and versatility.

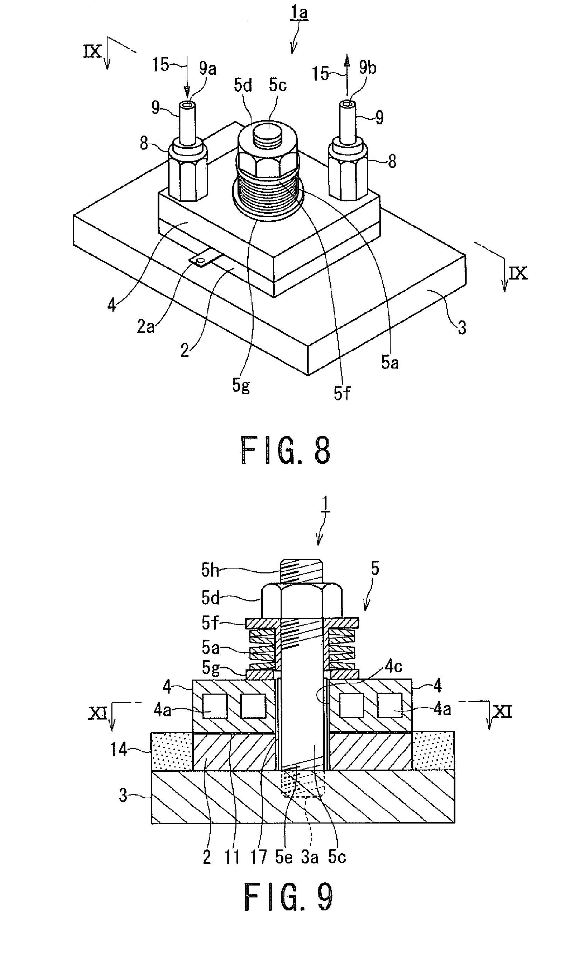

### [Fourth Embodiment (Figs. 8 to 12)]

The fourth embodiment of the present invention will be described hereunder with reference to Figs. 8 to 12. Fig. 8 is a perspective view illustrating a unit of a thermoelectric generator according to the present fourth embodiment. Fig. 9 is a sectional view illustrating the thermoelectric generator according to the present embodiment (sectional view taken along line IX-IX in Fig. 8). It is to be noted that the basic structure or configuration of the fourth embodiment is the same as that of the first embodiment, and the same reference numerals or characters are assigned to components or members corresponding to those of the first embodiment, and the duplicate description is omitted herein.

As illustrated in Figs. 8 and 9, according to the thermoelectric generator 1 of the present fourth embodiment, a rectangular hole 4c is provided commonly, for example, in central portions of the thermoelectric module 2 and the low temperature member 4, and the number of tie rods 5c is reduced to one. In other words, reduction of the number of the pressing members 5 having a function to generate pressure load and absorb thermal expansion to one portion can save the space of mounting area of the thermoelectric generator 1, thereby increasing the freedom of mounting place. Moreover, the amount of fastening the spring member 5a can be controlled at one position, thereby increasing the operability and structural reliability.

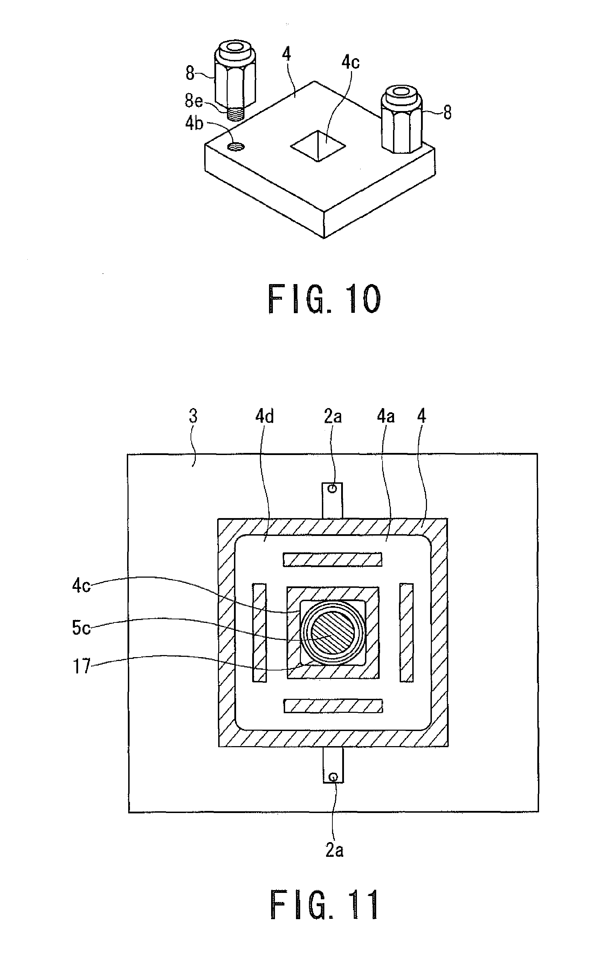

Fig. 10 illustrates a structure of mounting the joint 8 and the pipe 9 on the low temperature member 4. As illustrated in Fig. 10, the entrance and exit 4b of the low temperature medium passage 4a is formed as a screw hole, for example, on an outer surface of the low temperature member 4, and the joint 8 for connecting the pipe 9 is screwed to be mounted thereto. A rectangular hole through which the tie rod 5c can pass is provided in the center of the low temperature member, and this hole may be formed in a circular shape.

Fig. 11 is an illustration of the low temperature medium passage 4a and portions associated therewith in the low temperature member 4. As illustrated in Fig. 11, the low temperature member 4 includes the low temperature medium passage 4a which supplies the low temperature medium 15 from a cooling facility (not illustrated). The low temperature medium passage 4a is formed, for example, as a quadrangular annular passage. Further, the low temperature medium passage 4a may be formed as a serpentine passage. When the outer surface of the thermoelectric module 2 illustrated in Fig. 8 comes into contact with the low temperature member 4, the thermoelectric module 2 is cooled from the outer surface side of the generator.

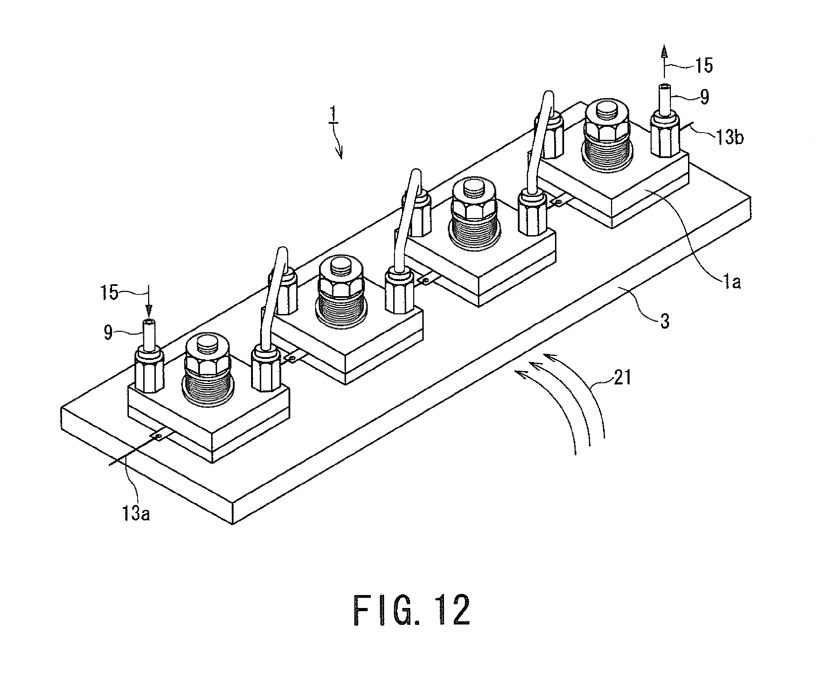

Fig. 12 is a perspective view showing an entire configuration of the thermoelectric generator according to the present embodiment. As illustrated in Fig. 12, according to the present embodiment, four thermoelectric generator units are evenly mounted on the high temperature member 3 and are connected by an electrical wiring 13. The example illustrates that the high temperature member 3 receives radiant heat 21 from a heat source (not illustrated). According to the structure of the present embodiment mentioned above, the main components or members of the thermoelectric generator 1 can be mounted on a portion defended or cooled by a common heat insulated wall as well as the surroundings of a blast furnace or an incinerator in a steel plant with good operability.

As described above, according to the present embodiment, the thermoelectric generator can provide an efficient conversion from the thermal energy to the electrical energy, having a compact structure at high performance, and being excellent in structural health and operability.

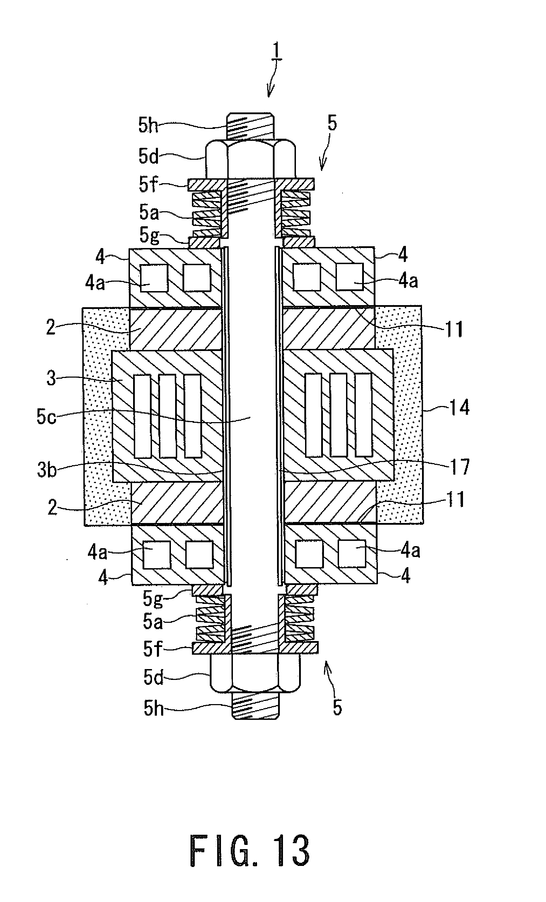

### [Fifth embodiment (Fig. 13)]

The fifth embodiment of the present invention will be described with reference to Fig. 13. Fig. 13 is a sectional view illustrating a thermoelectric generator according to the present embodiment. Further, it is to be noted that the basic structure or configuration of the fifth embodiment is the same as that of the fourth embodiment, and hence, the same reference numerals or characters are assigned to components or members corresponding to those of the first to fourth embodiments, and the duplicate description is omitted herein.
The present embodiment specifies a structure in which two units of the thermoelectric generator are disposed facing each other on a parallel surface of a rectangular passage where the heat exchange fin is formed on the high temperature medium side of the high temperature member.

As illustrated in Fig. 13, the thermoelectric generator 1 of the present embodiment has approximately the same configuration as that of the fourth embodiment except the fastening configuration of the tie rod 5c. The configuration is made such that the fin 16 is formed on the high temperature medium side of the high temperature member 3 so as to perform heat exchanging operation at high performance. The high temperature member 3 includes a circular or rectangular tube-shaped through-hole 3b perpendicular to a surface on which the thermoelectric module 2 is mounted. The tie rod 5c is inserted through the inside of the through-hole 3b, and an anti-radiation plate 17 is provided between the through-hole 3b and the tie rod 5c so as to reduce thermal energy loss. Further, instead of the anti-radiation plate 17, a heat insulating material 14 may be filled therebetween. Further, since the through-hole 3b also acts as a roll of a fin, the performance will be improved.

Since, the tie rod 5c is not directly contacted to the high temperature member 3, the temperature of the tie rod 5c is difficult to increase. Consequently, during the operation, the amount of thermal expansion of the high temperature member 3 is larger than that of the tie rod 5c, and contrary to the fourth embodiment, the fastening force by the pressing member 5 is applied in a direction of increasing the fastening force. The fastening force increases the adhesion between the high temperature member 3 and the thermoelectric module 2, and reduces the contact thermal resistance between the high temperature member 3 and the thermoelectric module 2. Further, in the structure of Fig. 13, although the spring member 5a is mounted on both ends of the tie rod 5c, it may be mounted on one end side thereof.

According to the present embodiment, since the thermoelectric module 2 and the low temperature member 4 are disposed opposing and in parallel to a surface of the high temperature member 3 and are fastened by the tie rod 5c via the pressing member 5, a uniform contact surface pressure can be provided between the high temperature member 3 and the thermoelectric module 2, and between the thermoelectric module 2 and the low temperature member 4.

Moreover, according to the present embodiment, it is not necessary to alternately tighten the nuts as a method of adjusting the fastening force to a plurality of tie rods 5c, and hence, the present embodiment is excellent in assembling performance.

As described above, according to this embodiment, the thermoelectric generator can provide an efficient conversion from thermal energy to electrical energy with a compact structure at high performance, and being excellent in structural reliability and versatility.

## Claims

1. A thermoelectric generator comprising:
a high temperature member which conducts thermal energy of a high temperature medium;
a low temperature member which is provided on a side opposing to the high temperature medium of the high temperature member and is provided with a low temperature medium passage therein;
a thermoelectric module which is sandwiched between the high temperature member and the low temperature member and carries out a thermoelectric conversion element converting a thermal energy to an electrical energy using a temperature difference between the high temperature medium and the low temperature medium supplied to the low temperature medium passage; and
at least one tie rod fastening between the low temperature member and the high temperature member.

2. The thermoelectric generator according to claim 1, wherein the high temperature member has two surfaces in parallel to each other, the thermoelectric module and the low temperature member are provided on the parallel surfaces of the high temperature member, respectively, and the low temperature members are fastened to together by the tie rod.

3. The thermoelectric generator according to claim 1, wherein the high temperature member has two parallel surfaces and a through-hole connecting the two parallel surfaces, the thermoelectric module and the low temperature member are provided on each of the parallel surfaces of the high temperature member, and the low temperature members are fastened together with the tie rod.

4. The thermoelectric generator according to claim 1, wherein the low temperature member, the thermoelectric module, and the tie rods are combined into one unit, and a plurality of such units are arranged on the high temperature member.

5. The thermoelectric generator according to claim 1, further comprising, as a member for fastening the low temperature member and the high temperature member by means of the tie rod, a plurality of spring members whose contact portion forms a line contact are provided.

6. The thermoelectric generator according to claim 1, wherein the low temperature member is composed of a base material and a passage material forming a passage, and the passage material has a rigidity equal to or greater than a rigidity of the base material.

7. The thermoelectric generator according to claim 6, wherein the base material is formed of an element selected from aluminum, copper, iron, molybdenum, titanium, nickel, tin, zirconium, zinc, and magnesium, or a compound or an alloy containing any one of the above elements as main component thereof.

8. The thermoelectric generator according to claim 1, wherein the thermoelectric conversion element is a direct thermoelectric conversion semiconductor formed of at least three or more elements selected from rare earth element, uranium, thorium, plutonium, cobalt, nickel, iron, rhodium, ruthenium, palladium, platinum, antimony, titanium, zirconium, hafnium, tin, silicon, manganese, zinc, boron, carbon, nitrogen, oxygen, gallium, germanium, indium, vanadium, niobium, barium, magnesium, chromium, tantalum, molybdenum, and aluminum.

9. The thermoelectric generator according to claim 1, wherein the direct thermoelectric conversion semiconductor has a crystal structure of any one of a skutterudite structure, a filled skutterudite structure, a Heusler structure, a half-Heusler structure, and a clathrate structure.

10. The thermoelectric generator according to claim 9, wherein the crystal structure of the direct thermoelectric conversion semiconductor is at least one or a compound or a mixture or a solid solution of a layered complex oxide of cobalt and a substance selected from copper oxide, carbon, boron, sodium, and calcium; aluminum nitride; uranium nitride; silicon nitride; molybdenum disulfide; a thermoelectric conversion material containing cobalt antimonide compound having a skutterudite crystal structure as the main phase; a thermoelectric conversion material containing clathrate compound as the main phase; and a thermoelectric conversion material containing half-Heusler compound as the main phase.
